# DEMANDE DE BREVET EUROPEEN

(11) **EP 4 575 670 A1**
(43) Date de publication de la demande: **25.06.2025**
(21) Numéro de dépôt: 23218769.0
(22) Date de dépôt: 20.12.2023
(51) Int. Cl.: G04B 19/12, A44C 27/00, C23C 14/00, G02B 17/00, G02F 2/00, G04B 45/00

(54) **COMPOSANT D'HABILLAGE COMPRENANT UN SUBSTRAT PRÉSENTANT DES VARIATIONS LOCALES D'INDICE DE RÉFRACTION ET PROCÉDÉ DE FABRICATION D'UN TEL COMPOSANT D'HABILLAGE**

(71) Demandeur: The Swatch Group Research and Development Ltd, 2074 Marin (CH)
(72) Inventeur: HALLER, Camille, 1400 Yverdon-les-Bains (CH); MORADI, Mina, 4600 Olten (CH); SPASSOV, Vladislav, 1788 Praz (CH); GSTALTER, Marion, 25570 Grand'Combe Châteleu (FR); ODEH, Ahmad, 1020 Renens (CH); SPRINGER, Simon, 3007 Berne (CH)
(74) Mandataire: ICB SA

(57) **Abrégé**

L'invention concerne un composant d'habillage (10) comprenant un substrat (11) présentant une face d'habillage (110) et comportant une zone décorative (12, 13), une première portion (111) de la face d'habillage (110) étant définie par la zone décorative (12, 13), le reste de la face d'habillage (110) définissant une seconde portion (112) de la face d'habillage (110), la première portion (111) de la face d'habillage (110) présentant un indice de réfraction différent de celui de la seconde portion (112) de la face d'habillage (110), l'ensemble de ladite face d'habillage (110) étant recouverte d'un revêtement (14) transparent et/ou translucide dont l'épaisseur est comprise entre 5 nm et 1 µm de sorte à conférer à la face d'habillage (110) des couleurs interférentielles, la couleur des première et seconde portions (111, 112) de la face d'habillage (110) étant différentes.

## Description

### Domaine technique de l'invention

L'invention relève du domaine de l'horlogerie, de la bijouterie ou de la joaillerie et concerne en particulier un composant d'habillage comprenant un substrat présentant des variations locales d'indice de réfraction.

### Arrière-plan technologique

Les couches minces sont couramment utilisées dans le domaine de l'horlogerie notamment, pour modifier les propriétés optiques, et donc l'aspect esthétique de la surface visible des composants d'habillage.

Plusieurs méthodes peuvent être mises en oeuvre pour déposer des couches minces, parmi lesquelles le dépôt physique en phase vapeur, connu sous le sigle « PVD » pour « physical vapor déposition » en langue anglaise, le dépôt chimique en phase vapeur, connu sous le sigle « CVD » pour « chemical vapor déposition », la déposition de couches atomiques, connue sous le sigle « ALD » pour « Atomic Layer Déposition », ou la croissance galvanique.

Les couches minces peuvent être réalisées en métal pur, en alliages de métaux, ou en matériaux céramiques.

Néanmoins, ces couches minces proposent une gamme de couleurs intrinsèques relativement limitée selon leur composition et leur épaisseur.

Une plus grande gamme de couleurs et des couleurs plus saturées peuvent être obtenues grâce aux couleurs interférentielles obtenues par l'empilement de différentes couches minces, typiquement réalisées en matériau translucides, déposées sur une couche réfléchissante.

Toutes les couches minces précitées sont monochromes et un décor multicolore exige autant d'étapes de dépôts que de couleurs désirées, lesdites étapes de dépôt étant suivies d'étapes de structuration intermédiaires typiquement effectuées par photolithographie et gravure chimique, procédé dit « lift-off », « shadow mask », ou ablation par laser ou par gravure ionique réactive.

Ces étapes de structuration se révèlent souvent fastidieuses et onéreuses afin de respecter les exigences de tolérances.

Il existe, par conséquent, un besoin de fournir un composant présentant plusieurs couleurs vives et saturées sur une large gamme de couleurs.

### Résumé de l'invention

La présente invention concerne un composant d'habillage comprenant un substrat présentant une face d'habillage et comportant une zone décorative, une première portion de la face d'habillage étant définie par la zone décorative, le reste de la face d'habillage définissant une seconde portion de la face d'habillage. La première portion de la face d'habillage présente un indice de réfraction différent de celui de la seconde portion, l'ensemble de ladite face d'habillage étant recouverte d'un revêtement transparent ou translucide dont l'épaisseur est comprise entre 5 nm et 1 µm de sorte à conférer à la face d'habillage des couleurs interférentielles, la couleur des première et seconde portions de la face d'habillage étant différentes.

On appelle dans le présent texte « couleur interférentielle » une couleur générée par un phénomène optique d'interférence.

Ainsi, une large gamme de couleurs saturées et intenses peut être générée sur un composant d'habillage de façon relativement simple.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, la zone décorative du substrat présente une phase cristalline et le reste du substrat présente une phase amorphe ou inversement.

Dans des modes particuliers de réalisation, la zone décorative du substrat et le reste du substrat présentent des structures cristallines différentes.

Dans des modes particuliers de réalisation, la zone décorative du substrat et le reste du substrat présentent des orientations de plans cristallins différents.

Dans des modes particuliers de réalisation, la zone décorative du substrat présente une composition chimique différente de celle du reste de la face d'habillage.

Dans des modes particuliers de réalisation, le substrat est en métal, en verre, en saphir, en matériau céramique, en polymère ou en matériau composite à matrice métallique.

Dans des modes particuliers de réalisation, le revêtement est formé par une couche d'oxyde, de nitrure, de fluorure, de carbure, de borure ou d'une combinaison d'au moins deux de ces éléments.

Dans des modes particuliers de réalisation, le revêtement est formé par un empilement de couches réalisées en oxyde, en nitrure, en fluorure, en carbure et/ou d'une combinaison d'au moins deux de ces éléments.

Dans des modes particuliers de réalisation, le revêtement est formé par un empilement de couches composé de deux couches de TiO2 entre lesquelles est interposée une couche de Al2O3.

Dans des modes particuliers de réalisation, le revêtement est configuré de sorte à conférer au composant d'habillage une couleur caractérisée dans l'espace L*a*b* par L* compris entre 28 et 60, a* compris entre -9 et -0.6 et b* compris entre 21 et 31.

Un autre aspect de l'invention concerne un procédé de réalisation d'un décor sur un composant d'habillage par exemple conforme à celui précédemment décrit, comprenant une étape de traitement de surface local de la face d'habillage d'un substrat, dans laquelle une zone décorative est générée dans le substrat sur une partie de la face d'habillage de sorte à présenter un indice de réfraction différent de celui du reste de la face d'habillage, le procédé comprenant une étape de dépôt d'un revêtement sur l'ensemble de la face d'habillage réalisée de sorte que la face d'habillage présente des couleurs interférentielles.

Dans des modes particuliers de mise en oeuvre, l'étape de traitement de surface local est réalisée par laser de manière à générer un recuit local de la face d'habillage afin de produire la zone décorative par changement de phase, changement de structure cristalline, par diffusion de surface, par oxydation, par réduction ou par nitruration.

Dans des modes particuliers de mise en oeuvre, l'étape de traitement de surface local est réalisée par évaporation par faisceau d'électrons, par bombardement ionique, ou par lithographie par faisceau d'électrons de manière à générer un changement de composition chimique local de la face d'habillage afin de produire la zone décorative.

### Brève description des figures

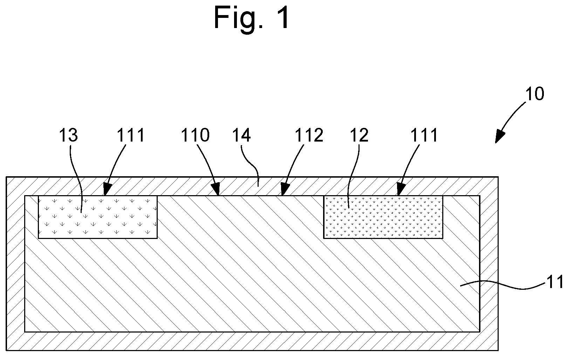

D'autres caractéristiques et avantages de l'invention apparaîtront à la lecture de la description détaillée suivante donnée à titre d'exemple nullement limitatif, en référence à la figure 1 représentant schématiquement une vue en coupe d'un composant d'habillage selon un exemple de réalisation de la présente invention.

### Description détaillée de l'invention

La présente invention concerne un composant d'habillage 10 comprenant un substrat 11 présentant, sur une première portion 111 d'une face d'habillage 110, au moins une zone décorative 12, 13. Le substrat 11 peut être réalisé en métal, en verre, en saphir, en matériau céramique, en polymère ou en matériau composite à matrice métallique, ou plus généralement en tout matériau dont l'arrangement atomique peut être modifié. A titre d'exemple, le substrat 11 peut être réalisé en CrNi, en CrC ou en alliage d'or et de nickel.

Sur la figure 1 est représenté un composant d'habillage 10 sur lequel s'étendent deux zones décoratives 12 et 13 différentes. Toutefois, pour faciliter la lecture du texte, une unique zone décorative est décrite ci-après.

La zone décorative 12 ou 13 est réalisée par traitement de surface local de la face d'habillage 110, de sorte que la zone décorative 12 ou 13 présente un indice de réfraction différent de celui du reste de la face d'habillage 110, c'est-à-dire d'une seconde portion 112 de la face d'affichage 110, non traitée. Par la notion de traitement de surface, dans le présent texte, on entend également éventuellement le traitement volumique, dans la mesure où ce dernier engendre un traitement surfacique. En particulier, comme le montre la figure 1, le traitement de surface générant la zone décorative 12 ou 13 s'étendant dans le volume du substrat 11. A titre d'exemple, la zone décorative 12 ou 13 résultant du traitement de surface peut s'étendre dans le volume du substrat jusqu'à une profondeur égale à 100µm.

L'ensemble de la face d'habillage 110 est recouvert d'un revêtement 14 transparent et/ou translucide dont l'épaisseur est comprise entre 5 nm et 1 µm, de sorte à conférer à la face d'habillage 110 des couleurs interférentielles. Les indices de réfraction de la zone décorative 12 ou 13, c'est-à-dire de la première portion 111 de la face d'habillage 110, et celui de la seconde portion 112 de la face d'habillage 110 étant différents, leurs couleurs sont différentes et la zone décorative 12 ou 13 compose un motif décoratif coloré sur la face d'habillage 110.

L'invention comporte plusieurs variantes de réalisation permettant de réaliser ce motif décoratif coloré.

Dans une première variante de réalisation, le substrat 11 est en phase amorphe et le traitement de surface local de la face d'habillage 110 permet de transformer localement la phase amorphe en phase cristalline. Ainsi, la zone décorative 12 ou 13 présente une phase cristalline et le reste du substrat 11 présente une phase amorphe.

Le traitement de surface local est réalisé préférentiellement par laser de manière à générer un recuit local de la face d'habillage. Ce recuit peut avoir pour effet de réduire ou d'oxyder localement la surface du substrat 11.

A l'inverse, le substrat 11 peut être en phase cristalline et le traitement de surface local de la face d'habillage 110 permet de transformer localement la phase cristalline en phase amorphe. Ainsi, la zone décorative 12 ou 13 présente une phase amorphe et le reste du substrat 11 présente une phase cristalline. Dans un tel exemple, le substrat 11 peut être réalisé en saphir ou en diamant.

Dans une deuxième variante de réalisation, la zone décorative 12 ou 13 est réalisée de sorte qu'elle présente une structure cristalline différente du reste du substrat 11.

Dans une troisième variante de réalisation, la zone décorative 12 ou 13 est réalisée de sorte qu'elle présente un plan cristallin orienté différemment par rapport à un plan cristallin du reste du substrat 11.

Dans ces variantes de réalisation, ces différentes configurations de la zone décorative 12 ou 13 sont obtenues selon le matériau du substrat 11 et les paramètres laser. La modification de ces paramètres selon le résultat souhaité est à la portée de l'homme du métier.

Dans une quatrième variante de réalisation de l'invention, la zone décorative 12 ou 13 est réalisée de sorte à présenter une composition chimique différente de celle de la seconde portion 112 de la face d'habillage 110. A titre d'exemple, le substrat 11 peut être traité localement par évaporation par faisceau d'électrons ou par lithographie de manière à générer un changement de composition chimique local de la face d'habillage afin de produire la zone décorative 12 ou 13.

En particulier, une migration d'atomes du substrat 11 jusqu'à la face d'habillage 110 peut se produire, par exemple si le substrat 11 est réalisé dans un alliage métallique ou dans du silicium cristallin dopé. Par ailleurs, une perte d'atomes peut se produire, par exemple par évaporation, ou un gain d'atomes sur la face d'habillage 110, par exemple par oxydation à l'air ambiant ou par nitruration sous atmosphère contrôlée.

La perte ou le gain d'atomes peut être réalisé par pulvérisation cathodique ou par toute autre méthode adaptée.

Pour obtenir au moins deux zones décoratives 12 et 13 différentes sur la face d'habillage 110, plusieurs solutions de traitement de surface local parmi celles mentionnées précédemment sont mises en oeuvre.

Le revêtement 14 peut être formé par une couche d'oxyde, de nitrure, de fluorure, de carbure, de borure ou d'une combinaison d'au moins deux de ces éléments, ou il peut être formé par un empilement de ces couches. Il est préférentiellement déposé par méthode ALD ou PVD. Alternativement, il peut être déposé par toute méthode de dépôt de couche mince appropriée.

En particulier, dans un exemple de réalisation, le revêtement 14 est formé par un empilement de couches composé de deux couches de TiO2 entre lesquelles est interposée une couche de Al2O3. Plus précisément, une première couche de TiO2 est déposée sur la face d'habillage 110 du substrat 11 et présente une épaisseur comprise entre 5 et 15 nm, voire entre 6.5 et 9. Une couche de Al2O3 est déposée sur la première couche de TiO2 et présente une épaisseur comprise entre 60 et 70 nm, par exemple entre 62 et 68 nm. Enfin, une seconde couche de TiO2 est déposée sur la couche de Al2O3 et présente une épaisseur comprise entre 25 et 35 nm, par exemple entre 28 et 31 nm.

Ces caractéristiques du revêtement 14, en combinaison avec un substrat 11 réalisé en verre, permet de conférer au composant d'habillage 10 une couleur caractérisée dans l'espace L*a*b* par L* compris entre 28 et 60, a* compris entre -9 et -0.6 et b* compris entre 21 et 31. En particulier, le composant d'habillage 10 présente une couleur verte ; la première portion 111, c'est-à-dire la ou les zones décoratives 12 et 13, autrement dit la première portion 111,et la seconde portion 112 de la face d'habillage 110 présentant respectivement des nuances de vert différentes.

De manière générale, le revêtement 14 peut être constitué par un empilement de couches chacune dimensionnée de sorte à présenter une épaisseur comprise entre 1 et 100 nm et de sorte que le revêtement présente une épaisseur comprise entre 5 et 200 nm.

De manière plus générale, il est à noter que les modes de mise en oeuvre et de réalisation considérés ci-dessus ont été décrits à titre d'exemples non limitatifs, et que d'autres variantes sont par conséquent envisageables.

Il y a lieu de noter que, dans le présent texte, le substrat 11 peut être constitué par un corps de substrat et par un revêtement déposé sur ledit corps de substrat. Dans ce cas, la face d'habillage 110 du substrat 11 est matérialisée par la face visible du revêtement et la ou les zones décoratives 12 et 13 sont formées dans ledit revêtement.

## Revendications

1. Composant d'habillage (10) comprenant un substrat (11) présentant une face d'habillage (110) et comportant une zone décorative (12, 13), une première portion (111) de la face d'habillage (110) étant définie par la zone décorative (12, 13), le reste de la face d'habillage (110) définissant une seconde portion (112) de la face d'habillage (110), le composant d'habillage (10) étant **caractérisé en ce que** la première portion (111) de la face d'habillage (110) présente un indice de réfraction différent de celui de la seconde portion (112) de la face d'habillage (110), l'ensemble de ladite face d'habillage (110) étant recouverte d'un revêtement (14) transparent et/ou translucide dont l'épaisseur est comprise entre 5 nm et 1 µm de sorte à conférer à la face d'habillage (110) des couleurs interférentielles, la couleur des première et seconde portions (111, 112) de la face d'habillage (110) étant différentes.

2. Composant d'habillage (10) selon la revendication 1, dans lequel la zone décorative (12, 13) présente une phase cristalline et le reste du substrat (11) présente une phase amorphe ou inversement.

3. Composant d'habillage (10) selon la revendication 1, dans lequel la zone décorative (12, 13) et le reste du substrat (11) présentent des structures cristallines différentes.

4. Composant d'habillage (10) selon la revendication 1, dans lequel la zone décorative (12, 13) et le reste du substrat (11) présentent des orientations de plans cristallins différents.

5. Composant d'habillage (10) selon la revendication 1, dans lequel la zone décorative (12, 13) présente une composition chimique différente de celle du reste de la face d'habillage (110).

6. Composant d'habillage (10) selon l'une des revendications 1 à 5, dans lequel le substrat (11) est en métal, en verre, en saphir, en matériau céramique, en polymère ou en matériau composite à matrice métallique.

7. Composant d'habillage (10) selon l'une des revendications 1 à 6, dans lequel le revêtement (14) est formé par une couche d'oxyde, de nitrure, de fluorure, de carbure, de borure ou d'une combinaison d'au moins deux de ces éléments.

8. Composant d'habillage (10) selon l'une des revendications 1 à 6, dans lequel le revêtement (14) est formé par un empilement de couches réalisées en oxyde, en nitrure, en fluorure, en carbure et/ou d'une combinaison d'au moins deux de ces éléments.

9. Composant d'habillage (10) selon la revendication 8, dans lequel le revêtement (14) est formé par un empilement de couches composé de deux couches de TiO2 entre lesquelles est interposée une couche de Al2O3.

10. Composant d'habillage (10) selon l'une des revendications 1 à 9, dans lequel le revêtement (14) est configuré de sorte à conférer au composant d'habillage (10) une couleur **caractérisée** dans l'espace L*a*b* par L* compris entre 28 et 60, a* compris entre -9 et -0.6 et b* compris entre 21 et 31.

11. Procédé de réalisation d'un décor sur un composant d'habillage (10), **caractérisé en ce qu'**il comprend une étape de traitement de surface local de la face d'habillage (110) d'un substrat (11), dans laquelle une zone décorative (12, 13) est générée dans le substrat, sur une partie de la face d'habillage (110), de sorte à présenter un indice de réfraction différent de celui du reste de la face d'habillage (110), le procédé comprenant une étape de dépôt d'un revêtement (14) sur l'ensemble de la face d'habillage (110) réalisée de sorte que la face d'habillage (110) présente des couleurs interférentielles.

12. Procédé selon la revendication 11, dans lequel l'étape de traitement de surface local est réalisée par laser de manière à générer un recuit local de la face d'habillage afin de produire la zone décorative (12, 13) par changement de phase, changement de structure cristalline, par diffusion de surface, par oxydation, par réduction ou par nitruration.

13. Procédé selon la revendication 11, dans lequel l'étape de traitement de surface local est réalisée par évaporation par faisceau d'électrons, par bombardement ionique, ou par lithographie par faisceau d'électrons de manière à générer un changement de composition chimique local de la face d'habillage afin de produire la zone décorative (12, 13).
